(19) Europäisches Patentamt / European Patent Office / Office européen des brevets

(11) **EP 3 141 915 A1**

(12) **EUROPEAN PATENT APPLICATION**

(43) Date of publication:
**15.03.2017 Bulletin 2017/11**

(51) Int Cl.:
***G01R 21/01*** (2006.01)  ***G01D 4/00*** (2006.01)
***H02J 3/14*** (2006.01)

(21) Application number: **16187161.1**

(22) Date of filing: **05.09.2016**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**MA MD**

(30) Priority: **11.09.2015 EP 15306391**

(71) Applicant: **Thomson Licensing
92130 Issy-les-Moulineaux (FR)**

(72) Inventors:
• **LOUZIR, Ali
35576 CESSON-SÉVIGNÉ (FR)**
• **KUMAR, Rupesh
35576 CESSON-SÉVIGNÉ (FR)**
• **LE NAOUR, Jean-Yves
35576 CESSON-SÉVIGNÉ (FR)**

(74) Representative: **Novagraaf Technologies
12 Place des Halles Saint Louis
56100 Lorient (FR)**

(54) **ELECTRICAL ACTIVITY SENSOR DEVICE FOR DETECTING ELECTRICAL ACTIVITY AND ELECTRICAL ACTIVITY MONITORING APPARATUS**

(57) An electrical activity sensor attachable to a power cable of an electrical device and comprising a magnetometer for detecting a variation of magnetic field caused by current in the power cable when the electrical device is powered; a processor configured to determine electrical activity of the electrical device based on the detected variation of magnetic field; and an antenna for transmitting a signal representative of the electrical activity to a reader device.

FIG. 1

**Description**

TECHNICAL FIELD

The present invention relates to an electrical activity sensor device for detecting the electrical activity of an electrical device connected to a power supply network, in particular the change in electrical power state and to an electrical activity monitoring apparatus for monitoring the electrical activity of one or more electrical devices.

BACKGROUND

The monitoring of electrical activity of electrical devices finds many useful applications in areas such as energy consumption, building user activity profiles, and security or safety monitoring systems. For example, in a home environment knowledge of the activity of electrical appliances such as washing machines, lighting devices; cookers, toaster or a coffee machine may provide useful information on the household habits and user activity enabling a profile to be built up.

A known solution for monitoring the activity of electrical devices employs a complex electrical meter system based on remote controlled modules plugged into power outlets and configured to measure the electrical consumption of the electrical equipment powered from the respective power outlet. Such, remote controlled modules are typical equipped with a wireless communication system generally based on low power wireless technology to remotely monitor and control the corresponding electrical appliance. Such advanced meter systems require however a complex and expensive customized installation. Indeed, a recent research report on home automation and monitoring indicated price and technical complexity as being the main market hurdles and inhibitors against widespread adoption. Another drawback of such techniques is that electrical devices may be moved from one power outlet to another power outlet. Moreover some devices such as lighting devices are not always powered from a power outlet.

Other solutions for the detection of the activity of electrical devices are based on sensing their "EMI (electromagnetic interference) signature" by monitoring the powerlines at one or several points of the power supply network. These techniques require however a customised calibration and training process to learn the EMI signature of various devices. Moreover the EMI signatures may evolve with time. Complex signal processing techniques are required to disaggregate the signatures of the various active devices connected to the network and the obtained results are not always very accurate.

The present invention has been devised with the foregoing in mind.

SUMMARY

In a general form the invention concerns an electrical activity sensor device based on an antenna device such as for example a radio frequency identification device (RFID), coupled to a magnetometer device.

According to a first aspect of the invention there is provided an electrical activity sensor attachable to a power cable of an electrical device and comprising a magnetometer for detecting a variation of magnetic field caused by current in the power cable when the electrical device is powered; a processor configured to determine electrical activity of the electrical device based on the detected variation of magnetic field; and an antenna for transmitting a signal representative of the electrical activity to a reader device.

In an embodiment, the antenna comprises an RFID antenna coupled to an RFID circuit

In an embodiment, the magnetometer is arranged on the power cable between two electrical wires of the power cable

In an embodiment, the processor is configured to compute the standard deviation of magnetic field data acquired by the magnetometer and to compare the computed standard deviation with a set of thresholds.

In an embodiment, the computation of standard deviation is performed on two axes perpendicular to the longitudinal axis of the power cable

In an embodiment, the set of thresholds are based on the magnetic field variation measured on the power cable for an unpowered state of the electrical device

In an embodiment, the magnetometer and the antenna are provided on a flexible substrate for wrapping at least partially around the power cord.

According to a second aspect of the invention there is provided an electrical activity monitoring apparatus for monitoring the electrical power status of at least one electrical device connected to a power supply network by a respective power cable and, the electrical activity monitoring apparatus comprising:

    a reader module for reading data received wirelessly from at least one electrical activity sensor device attached to a respective power cable of an electrical device wherein the data is received from the electrical activity sensor sensor device via wireless transmission from an antenna of the electrical activity sensor device and the data is representative of electrical power status change of the electrical device; and a monitor device for determining from the data received by the reader module, which electrical devices of the network have changed electrical power status.

A further aspect of the invention provides an electrical activity monitoring system comprising at least one electrical activity sensor according to any embodiment of the first aspect of the invention, and an electrical activity monitoring apparatus according to any embodiment of the second aspect of the invention.

A yet further aspect of the invention provides a method of detecting electrical activity of an electrical device powered via a power cable comprising: detecting a variation of magnetic field caused by current in the power cable when the electrical device is powered; determining electrical activity of the electrical device based on the detected variation of magnetic field; and transmitting a signal representative of the electrical activity to a reader device.

A yet further aspect of the invention provides a device for detecting electrical activity of an electrical device powered via a power cable comprising: at least one processor configured to:

detect a variation of magnetic field caused by current in the power cable when the electrical device is powered; determine electrical activity of the electrical device based on the detected variation of magnetic field; and transmitting a signal representative of the electrical activity to a reader device.

Some processes implemented by elements of the invention may be computer implemented. Accordingly, such elements may take the form of an entirely hardware embodiment, an entirely software embodiment (including firmware, resident software, micro-code, etc.) or an embodiment combining software and hardware aspects that may all generally be referred to herein as a "circuit", "module" or "system'. Furthermore, such elements may take the form of a computer program product embodied in any tangible medium of expression having computer usable program code embodied in the medium.

Since elements of the present invention can be implemented in software, the present invention can be embodied as computer readable code for provision to a programmable apparatus on any suitable carrier medium. A tangible carrier medium may comprise a storage medium such as a floppy disk, a CD-ROM, a hard disk drive, a magnetic tape device or a solid state memory device and the like. A transient carrier medium may include a signal such as an electrical signal, an electronic signal, an optical signal, an acoustic signal, a magnetic signal or an electromagnetic signal, e.g. a microwave or RF signal.

BRIEF DESCRIPTION OF THE DRAWINGS

Embodiments of the invention will now be described, by way of example only, and with reference to the following drawings in which:

FIG. 1 is a schematic block diagram of an electrical activity monitoring system in which one or more embodiments of the invention may be implemented

FIG. 2 is a schematic diagram of an electrical activity sensor device in accordance with a first embodiment of the invention;

FIG. 3 is a schematic diagram of the electrical activity sensor device of FIG. 2 for mounting on a power cable;

FIG. 4 - 7 are schematic diagrams illustrating the magnetic field around the power cord;

FIG. 8 is a schematic diagram of an electrical activity sensor device in accordance with an embodiment of the invention mounted in a power cord;

FIG. 9A-C graphically illustrates electrical activity signals in accordance with an embodiment of the invention;

FIG. 10A-C graphically illustrates electrical activity signals in accordance with an embodiment of the invention;

FIG. 11A-C graphically illustrates electrical activity signals in accordance with an embodiment of the invention;

FIG. 12 is a block diagram of components of an electrical activity sensor in accordance with an embodiment of the invention;

FIG. 13A is a flow chart illustrating steps of a method of detecting electrical activity in accordance with an embodiment of the invention;

FIG. 13B is a flow chart illustrating steps of a method of detecting electrical activity in accordance with an embodiment of the invention;

FIG. 14 is a flow chart illustrating steps of a method of detecting electrical activity in accordance with an embodiment of the invention; and

FIG. 15 is a flow chart illustrating steps of a method of detecting electrical activity in accordance with an embodiment of the invention.

FIG. 16 is a schematic block diagram of an electrical activity monitoring apparatus in accordance with an embodiment of the invention.

DETAILED DESCRIPTION

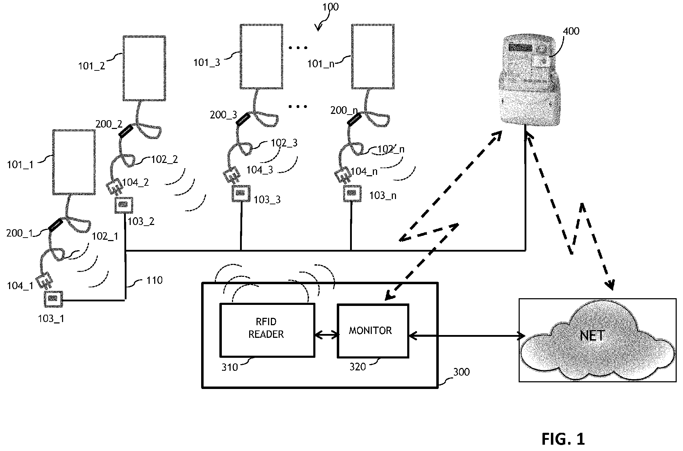

Figure 1 is a schematic block diagram of an electrical activity monitoring system in which one or more embodiments of the invention may be implemented. The electrical activity monitoring system 100 monitors the change in electrical status of n electrical devices 101_1 to 101_n. Each electrical device 101_1 to 101_n is connected by means of a respective electrical power cable 102_1 to 102_n to a power outlet 103_1 to 103_n of an electrical power supply network 110. It will be appreciated that while in the illustrated embodiment of Figure 1 each electrical device 101_1 to 101_n is connected to a respective power outlet 103_1 to 103_n, in other embodiments of the invention a plurality of electrical devices may be connected to the same power outlet 103_x.

Each electrical power cable 102_1 to 102_n is provided with a respective plug 104_1 to 104_n for connecting the respective electrical power cable to a respective power outlet 103_1 to 103_n for connection to the power supply network 110.

Each electrical power cable 102_1 to 102_n is further provided with a respective electrical activity sensor 200_1 to 200_n. Each electrical activity sensor 200_1 to 200_n is attached to a respective power cable 102_1 to 102_n. Each electrical activity sensor 200_1 to 200_n comprises an antenna and a magnetometer device.

The electrical activity monitoring system 100 further includes an electrical activity monitoring apparatus 300. The power supply network 110 is typically provided with an electricity meter 400 for measuring electrical consumption in the power supply network 110. The electrical activity monitoring apparatus 300 may be connected to a communication network NET such as an Internet network so that data on the electrical activity of the system may be transmitted to a remote device, such as a remote electrical activity monitoring device for example the server of a remote an electrical activity monitoring service or an electricity power supplier company.

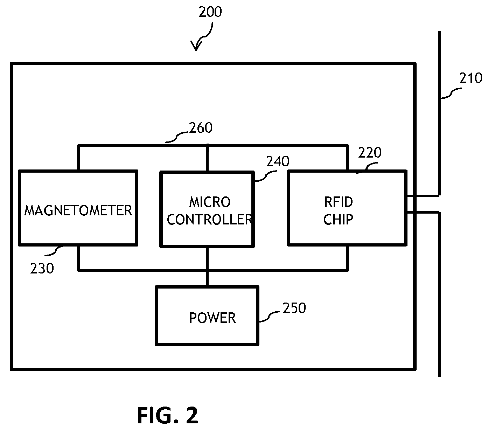

Figure 2 schematically illustrates an electrical activity sensor in accordance with an embodiment of the invention. The electrical activity sensor 200 comprises an antenna 210, an RFID circuit 220, a magnetometer device 230, a micro controller 240, a power supply such as a battery 250 and a data bus 260.

The antenna 210 and the RFID circuit 220 may be provided in the form of an RFID tag. The RFID circuit 220 is provided with a memory chip for storing data representative of electrical activity of the electrical device 101 and/or identification data identifying the RFID tag. Each RFID circuit 220 in the electrical monitoring system 100 is provided with an identification code enabling it to be identified by the monitoring device 300.

The function of the magnetometer device 230 is to detect the change in electrical status of the corresponding electrical device by detecting a variation in magnetic field in the power cord. The magnetometer device 230 may be a low-cost 3-axis magnetometer chip, such as that used in a smartphone for the detection of earth magnetic field (E-compass application). Examples, of such a magnetometer chip is the MAG3110 3-Axis Magnetometer from Freescale or the LIS3MDL Digital output 3-axis magnetic sensor from ST. The magnetometer device 230 is placed on the power cord with the RFID tag so that the magnetometer 230 couples efficiently to the variable magnetic field generated by the current flowing along the corresponding power cord 102 when the corresponding electrical device 101 is in the ON-state(s). This time-variable magnetic field (at the frequency of the 50-60 Hz AC current) adds in vector to the earth quasi-static magnetic field. Therefore the ON-states of the corresponding electrical device 101 may be inferred from the analysis of the time variability of the total magnetic field detected by the magnetometer device 230. The data bus 260 is used for writing data representative of the electrical power status of the electrical device (OFF or different ON states) into the memory of the RFID circuit 220. The micro controller 240 is configured to run one or more algorithms for acquisition of data by the magnetometer device 230, analysis of the acquired data and writing of data to the memory of the RFID circuit 220 via the data bus 260.

The RFID circuit 220 may be a new generation RFID chip such as, for example, an SL3S4011 _4021 chip from NXP or a MonzaX Chip from Impjin which offers, in addition to antenna access compliant with the EPC Gen 2 standard, a second wired interface, accessible via an $I^2C$ bus. The $I^2C$ bus 260 can be used for writing data representative of the electrical activity of the electrical device (OFF or different ON states) into the memory of the RFID chip 220. The data representative of the electrical activity of the electrical device is inferred from the analysis by the microcontroller 240 of the time variable magnetic field measured by the 3-axis magnetometer chip 230 and read through the databus interface. The microcontroller 240 may be an ultra-low power microcontroller such as for example PIC16MCU or PIC18MCU Microcontrollers families from Microchip.

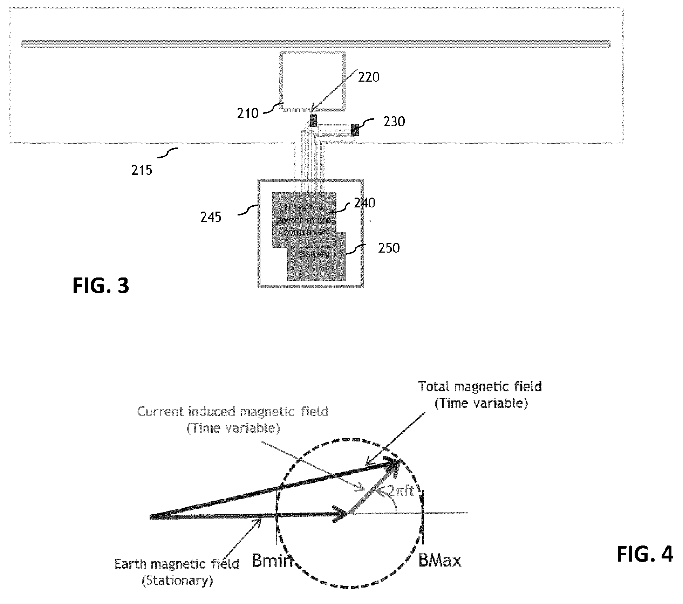

Figure 3 schematically illustrates the arrangement of the electrical activity sensor 200 of Figure 2.

The magnetometer chip 230 is attached to a flexible substrate 215 to be wrapped at least partially around the power cord 102 of the device 102, preferably in a position where, when wrapped, the magnetic field generated by the current flowing in the power cord 102 is maximum. The RFID antenna 210 and RFID chip 220 are also provided on the flexible substrate 215 and connected to a printed circuit board (PCB) 245 on which is provided the microcontroller 240 and power supply 250 by a connection strip providing the required interconnections between the magnetometer 230, the RFID chip 220 and the microcontroller 240. The PCB 240 also supports the battery 250 for powering the microcontroller 240, the magnetometer 230 and the RFID chip 220.

Figure 4 schematically illustrates the time-variation of the total magnetic field resulting from the earth magnetic field and the magnetic field generated by the current flowing in the power cord 102. When the electrical device 102 is OFF (no current flows along the power cord), the magnetic field detected by the magnetometer 230 is stationary corresponding to the earth's magnetic field at the location of the device, potentially perturbed by the proximity of the metallic wires inside the power cord 102 and more generally by the close ferromagnetic environment. When the electrical device 102 is switched ON, according to the Ampere's law, the current flowing in the power cord generates a time variable magnetic field at the frequency of 50-60 Hz corresponding to the power line frequency. The magnetic field induced by the current flowing in the power cord 102 adds in vector with the earth magnetic field resulting on a time variable total magnetic field at the frequency of the powerline current. The peak to peak variation (Bmax - Bmin) of the total magnetic field is proportional to the magnitude of the current (and thus the power) flowing along the power cord 102 and thus allows the knowledge of the power state of the electrical device in case of devices with several power states. The detection of the ON/OFF state is done by means of a power efficient algorithm running on the microcontroller 240. The algorithm is optimized so that it takes into account the variability of the quasi-stationary earth magnetic field due to the orientation change of the power cord 102 and/or the change of its ferromagnetic environment, while at the same time it minimizes the processing power.

When the flexible substrate 215 is wrapped around the power cord the position of the magnetometer chip 230 is preferably such that its coupling to the magnetic field generated by the power line current at ON state is maximum.

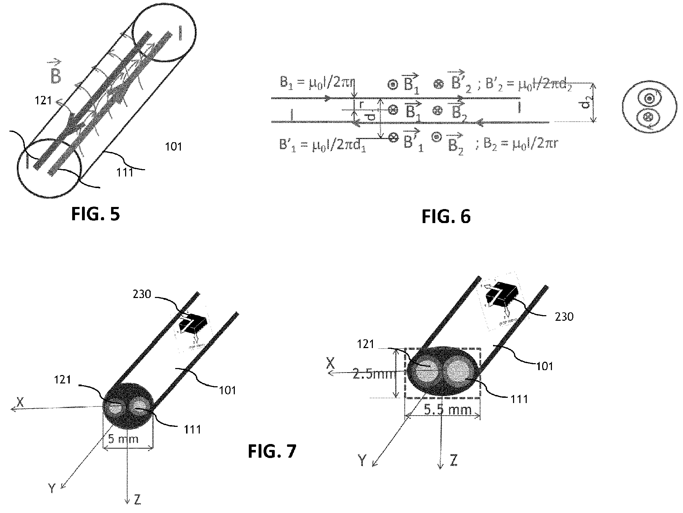

Figure 5 schematically illustrates the magnetic field lines generated by a 2-wire power cord supposed carrying a current of magnitude I, the two wires 111 and 121 being separated by a distance equal to 2r. With reference to Figure 6 the total magnetic field of the configuration of Figure 5 results from the superposition of the magnetic field generated by each wire supposed infinitely long. According to the Ampere's law, the magnitude B of the magnetic field generated by each wire at a distance r from the wire is equal to :

$$B = \mu_0 I/2\pi r;$$

And its direction is given by the "right hand rule". Therefore as sketched in Figure 6, because the currents flowing in the 2 wires are in opposite directions, the magnetic fields generated by the 2 wires, 111 and 121, add constructively between the 2 wires while they add destructively outside. More precisely, the magnitude of the total magnetic field B between the 2 wires is equal to:

$$B_{middle} = B_1 + B_2 = 2x\ \mu_0 I/2\pi r = \mu_0 I/\pi r$$

While at both sides of the power cord, the magnetic fields generated by each wire are in opposite directions resulting in weaker total magnetic fields equal to:

$$B_{up} = B_1 - B'_2 = \mu_0 I/2\pi r - \mu_0 I/2\pi d_2 = \mu_0 I/2\pi\ (1/r - 1/d_2)$$

$$B_{down} = B_2 - B'_1 = \mu_0 I/2\pi r - \mu_0 I/2\pi d_1 = \mu_0 I/2\pi\ (1/r - 1/d_1)$$

$d_1$, $d_2$, and r are shown in the Figure 6

Therefore, it is preferable that the magnetometer chip 230 be placed as close as possible to the wires and preferably between the 2 wires 111 and 121 of the power cord 102 as illustrated in examples of Figure 7. It may be noted that, in such conditions, the variable magnetic field induced by the 50-60 Hz current is mainly in the (X,Z) with dominant component in the Z plane, when the magnetometer device 230 is placed between the 2 wires.

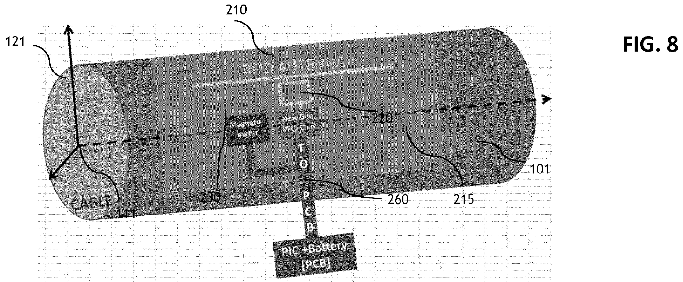

Figure 8 schematically illustrates the electrical activity sensor 200 arranged on the power cord 102. The PCB 145 provided with the microcontroller 240 and battery 250 is located externally to the power cord 102. The RFID chip 220 and the magnetometer 230 are provided on the flexible substrate 215 which is wrapped at least partially around the power cord 102.

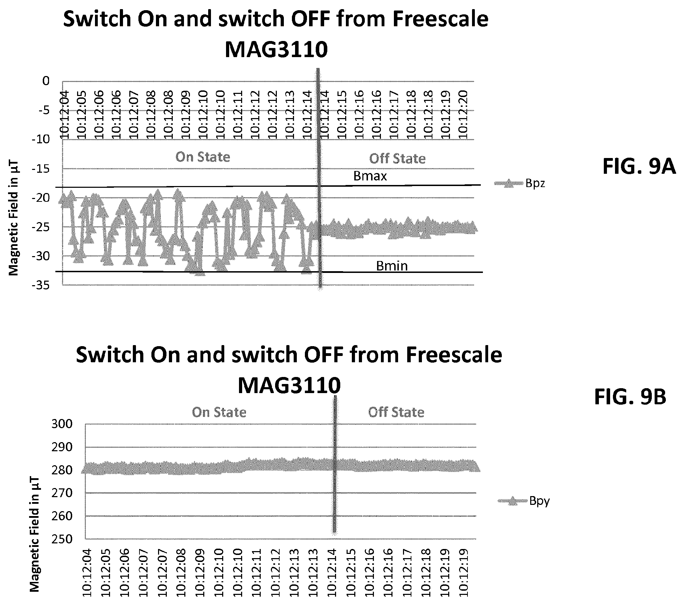

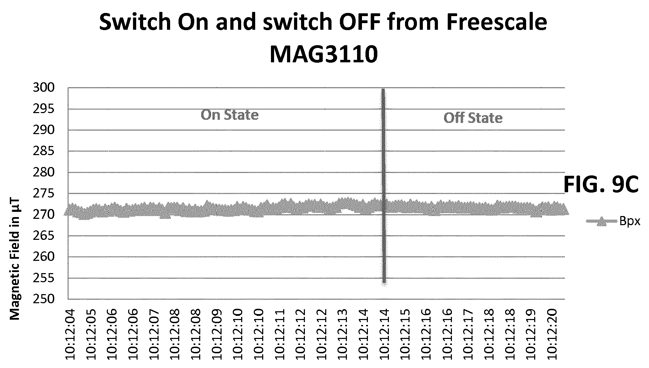

Figures 9A-C graphically illustrates the measured variation of the 3 components (Bpz, Bpy, Bpx) of the total magnetic field measured by a MAG3110 magnetometer 230 during a time interval of few seconds during which a desk lamp is switched from ON to OFF states. The longitudinal axis of the power cord 102 is aligned with Y axis of the magnetometer chip. As expected, time variable magnetic field is almost located in the (X,Z) plane (here mainly along the Z-axis) and the ON and OFF states could be easily discriminated.

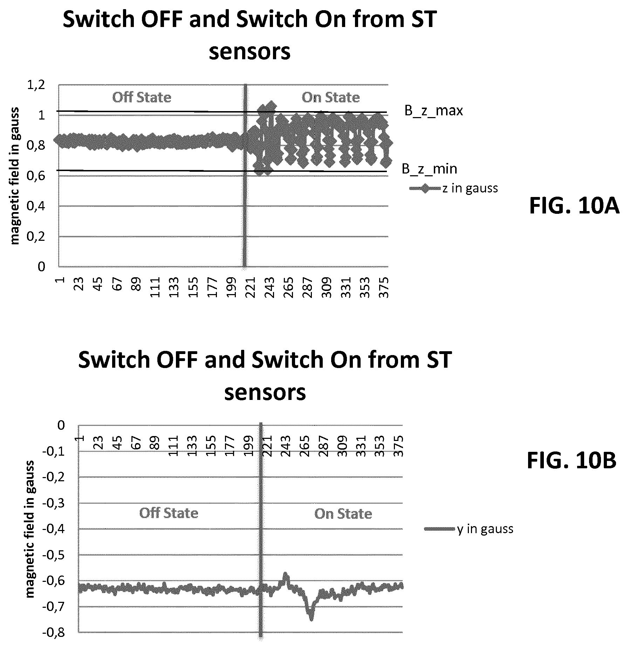

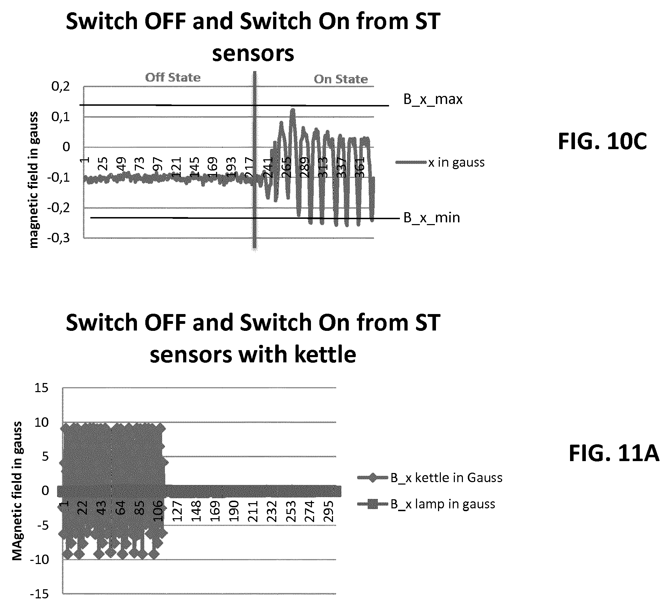

Figures 10A-C graphically illustrates the measured variation of the 3 components (Bpz, Bpy, Bpx) of the total magnetic field measured by a LIS3MDL magnetometer magnetometer 230 during a time interval of few seconds during which a desk lamp is switched from ON to OFF states.. The results confirm that 1/ ON and OFF states can be easily discriminated 2/ Given the relative position to power cord of the magnetometer, the time variable magnetic field induced by the current flowing in the cable during the ON-state is mainly located in the (X,Z) plane. The magnitude variation of the field components along each of the 2 axis depends on the orientation of the magnetometer with regard to the power cord in the (X,Z) plane.

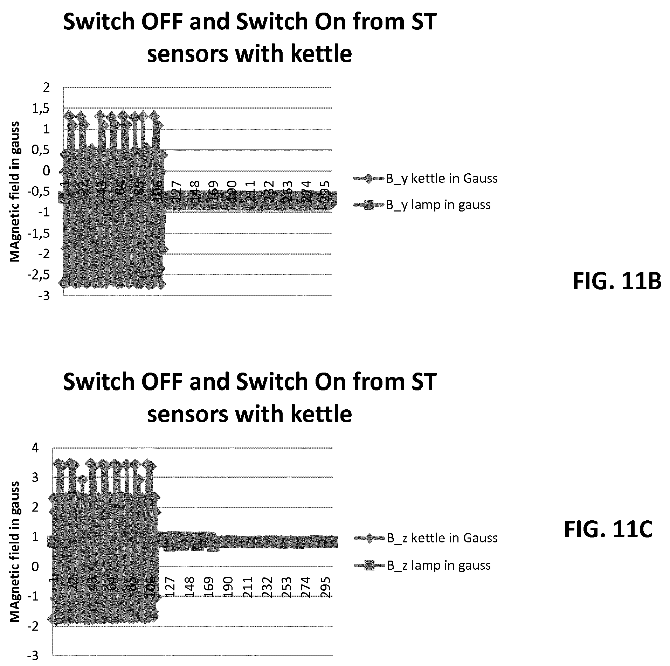

In order to confirm the possible discrimination between different power states the same measurements were performed with a kettle as the electrical device for which the electrical activity was being monitored. Figures 11A-C present the variation of the 3 components (Bz, By, Bx) of the total magnetic field measured by the magnetometer LIS3MDL during a time interval of few seconds during which the desk lamp was switched between the 2 power states ON/OFF compared with the measurements made with the lamp.

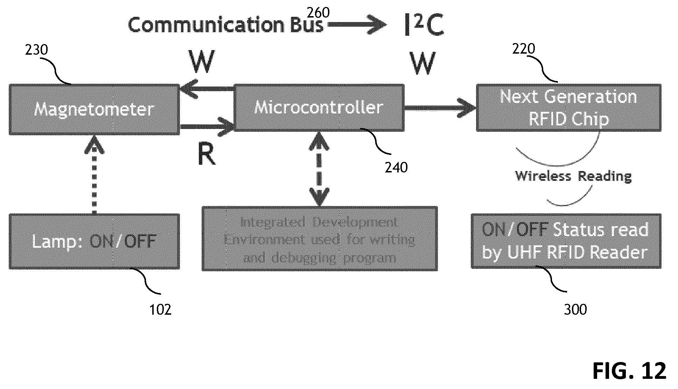

Figure 12 schematically illustrates shows the data bus 260 ($I^2C$ in this example) and wireless paths between the different components. The microcontroller 240, the magnetometer 230 and the RFID chip 220 are interconnected through the $I^2C$ communication bus 260. The microcontroller 240 establishes the $I^2C$ communication with the RFID chip 220 as well as the magnetometer 230; while the RFID antenna 210 remains directly connected with the RFID chip 220 for wireless communication with any UHF RFID Reader.

The microcontroller 240 computes the Standard Deviations ($SD_x$, $SD_y$, & $SD_z$) from the incoming magnetic field data for each axis and these computed values are compared with the Threshold-Standard Deviations ($SD_{xt}$, $SD_{yt}$, & $SD_{yt}$) which are pre-determined during the absence of current in the power cable, that is, OFF state of any tagged appliance, for example a lamp. The computed values ($SD_x$, $SD_y$, & $SD_z$) are compared in a sequential manner, that is, one-by-one axis and accordingly the RFID data represents the ON or OFF state. As explained, the X-axis is aligned with the power cable therefore it can be omitted from the working algorithm without any compromise to the performance.

In alternative embodiments of the invention the ON/OFF decision can be made with the computation based on the two axes provided the third axis should remain aligned to the one axis of the cable, i.e. along the cable's length.

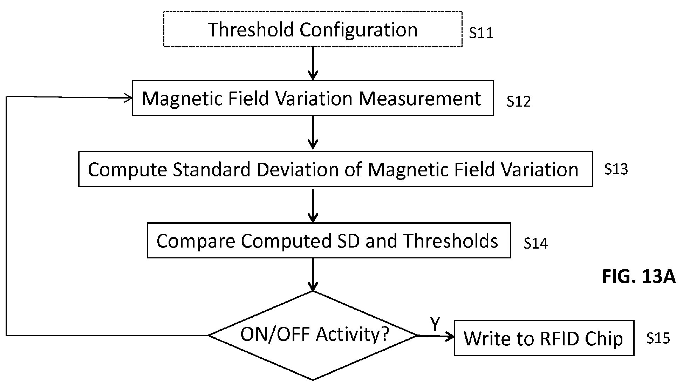

Figure 13A is a flow chart setting out steps of a method of processing magnetometer data in accordance with an embodiment of the invention.

In an initial configuration step S11 comparison thresholds are set for determining electrical activity of the electrical device 101. The comparison standard deviation thresholds ($SD_{xt}$, $SD_{yt}$, & $SD_{yt}$) are determined based on measurements of magnetic field variations during the absence of current in the power cable 102. In step S12 the magnetic field is measured by the magnetometer 230 in the 3 axes X, Y and Z during a predetermined time interval. In step S13 the Standard Deviations of the magnetic field in the 3 axes are computed by the microcontroller 240. In step S14 the computed standard deviations are compared with the standard deviation thresholds. In the case where the computed standard deviations are greater than the thresholds data is written to the RFID chip 230 in step S15 for transmission to the RFID reader 310 of the electrical activity monitoring system.

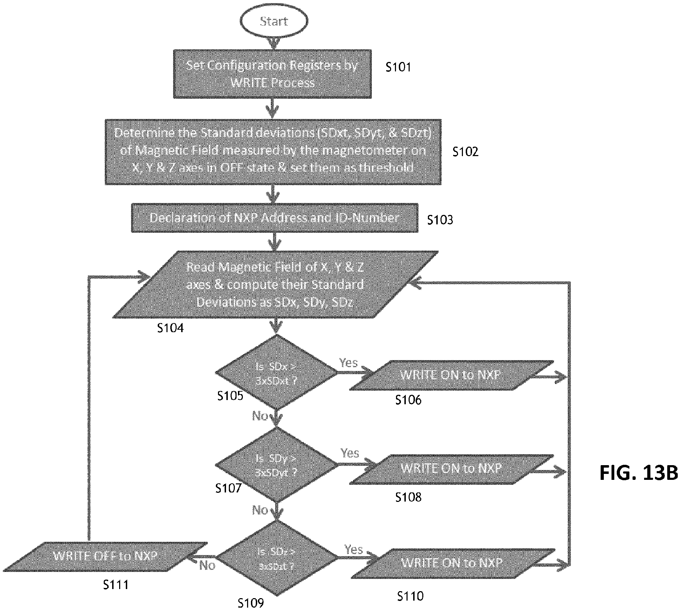

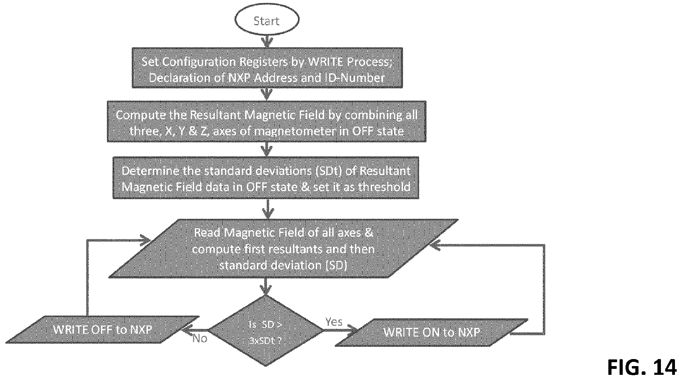

The algorithm of Figure 13B has considered each individual axis for computing their corresponding standard deviation. However, the resultant magnetic field from all three or two axes could be considered for the decision making between the ON and the OFF states. The algorithm based on the resultant magnetic field is depicted in Figure 14

Furthermore, this algorithm can also be used based on only two axes which remain unaligned to the cable's length.

Different power levels can be detected by the invention. Figures 11A-C show the different standard deviations of the magnetic fields' amplitudes due to the difference in power consumption between a lamp and a kettle. Different standard deviations of the variable magnetic field can be easily mapped for identifying different power levels of the tagged appliances. Such information have a direct application in some cases, for example, an 'Electric-Oven' has different power setting and these different states of power consumption can be easily monitored by a single tagged RFID with different ON states.

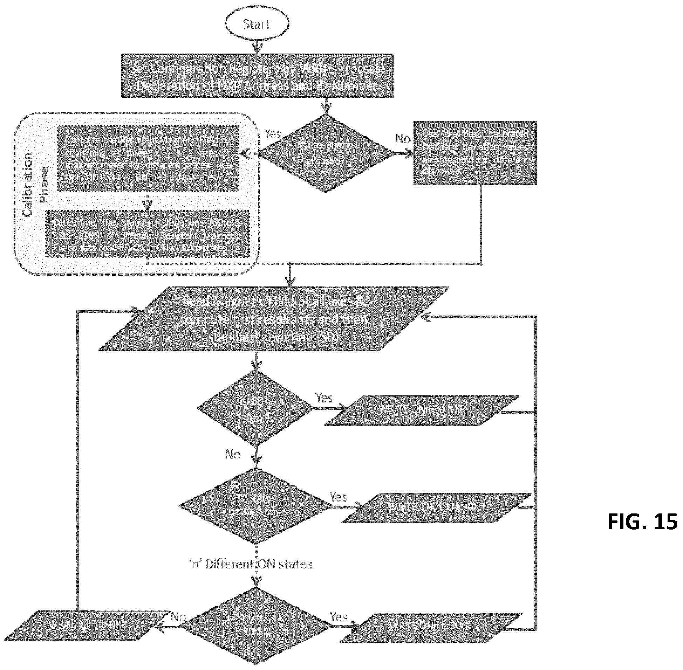

Figure 15 shows the algorithm for distinguishing 'n' different ON states (ON1, ON2,..., ONn) of any tagged appliance. As mentioned earlier, the standard deviation is used for the determination of ON/OFF state. Here too, the standard deviations of different ON states have been registered, we call this phase as *Calibration Phase,* and then these values are used to identify the corresponding different ON states.

The Calibration Phase can be opted by initiating an "interrupt signal" through a **Cali-Button,** excusive button installed on the PCB for opting calibration. So, whenever a new calibration is required, the user presses the Cali-Button at the start of the algorithm, otherwise, the algorithm will consider the previously calibrated values.

In this way, the different values of standard deviations corresponding to ON states can be calibrated. This gives the user an exclusively flexibility to customize the innovation as per the requirement. Henceforth, the user can have specific calibrated RFID for a dedicated appliance.

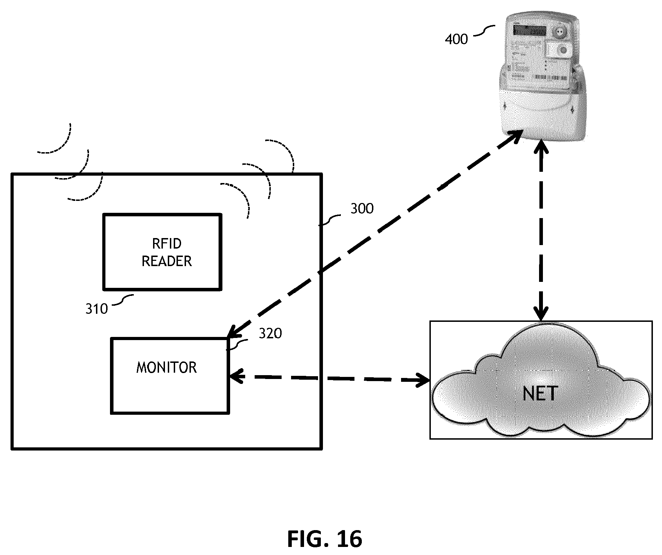

Figure 16 is a block diagram schematically illustrating an electrical activity monitoring apparatus 300 in accordance with an embodiment of the invention. The electrical activity monitoring apparatus 300 comprises an RFID reader device 310 and a monitoring device 320 for processing RFID data signals.

The RFID reader device 310 is a far field RFID type reader and is configured to wirelessly receive RFID data signals transmitted from the electrical activity sensors attached to the power cables 102 of the network via wireless transmission from the RFID antenna 210 and to send RFID interrogation signals to the RFID sensors 200 via wireless transmission to the respective RFID antenna 210.

Monitoring device 320 receives data from the RFID reader device 310 indicative of the electrical activity status of the electrical devices 101_1 to 101_n in the electrical activity monitoring system 100.

In one particular embodiment of the invention the monitoring device 320 is connected to a smart type electricity meter 400 connected to the power supply network 110 of the system. The electricity meter 400 and the monitoring 320 device may be connected by a wireless or wired connection. The smart electricity meter 400 is configured to monitor the power consumption of electrical devices 101_1 to 101_n connected to the power network 110. The smart electricity meter 400 is configured to detect a change in power consumption: for example an increase in the rate of power consumption which may result from the switching ON of one or more electrical devices 101_1 to 101_n supplied by the power network 110, or a decrease in the rate of power consumption which may result from the switching OFF or to STANDBY of one or more of the electrical devices 101_1 to 101_n supplied by the power network 110. In response to the detected change in power consumption a command signal is transmitted from the monitoring device 320 to the RFID reader device 310 to activate an RFID reading process. The RFID reader device 310 in response to the command signal transmits an interrogation signal to the RFID sensor devices 201_1 to 201_n in order to read the electrical status data stored in the respective RFID memory chips 230_1 to 230_n of the RFID sensor devices 201_1 to 201_n. The interrogation signal to be sent from the RFID reader 310 to one or more electrical activity sensors 200s by wireless transmission. Response signals are then transmitted by the electrical activity sensors 200_1 to 200_n towards the monitoring apparatus 300 by means of the respective antennas 210. The response signals from the RFID sensor devices 200_1 to 200_n each include the identification code of the respective electrical devices 102_1 to 102_n and the corresponding electrical power state change information stored in the respective RFID memory chip 230. The collected electrical power state change information signals are received and read by the RFID reader device 310. The processed electrical power state change activity information is then transmitted to the monitoring device 320.

Monitoring device 310 may further process the received power state change information or transfer the power state change information to another device, such as a remote device connected via a communication network.

For example, if an electrical device 101_x, for example a coffee machine, connected to a household power supply network 110 is switched ON (for example from an OFF power state or from a STANDBY mode):

1. The total power consumption will increase by an amount corresponding to the power consumed by the coffee machine. This change in power consumption will be measured by smart electricity meter 400.
2. The current impulse generated in the corresponding power cable in response to the switch on activates the corresponding electrical activity sensor device 201 attached to the respective power cable, and the status information change (OFF to ON) is stored in the RFID memory chip by switching a bit (the "state bit") from 0 (corresponding to OFF state) to 1 (corresponding to ON state)

The increase in power consumption measured by the smart electricity meter 400 may be detected by the monitoring device 320. In response to the detected increase a read command is sent to the RFID reader device 300 to trigger a read phase of the RFID reader device 310. The RFID reader module 310 reads all the RFID sensor devices 201_1 to 201_n of the electrical devices 101_1 to 101_n connected to the power network 110 by transmitting interrogation signals. The read information of each RFID sensor 201_1 nd includes its identification and its electrical ON/OFF change status.

In some embodiments of the invention by comparing the electrical change status of all the RFID sensor devices read with the previous one stored in an electrical devices status dataset, at the previous reading phase, it is possible to infer which electrical device has been powered on and the electrical devices status dataset may be updated accordingly.

In other embodiments of the invention, the state of the respective state bit signal stored on the corresponding RFID memory chip can be used to identify which electrical device or devices have been switched on or off.

In some particular embodiments of the invention for an electrical device an electrical pulse generated by an ON to OFF or STANDBY electrical power state change, may be distinguished from an electrical pulse generated by an OFF or STANDBY to ON electrical power state change by characterizing themagentic field variation. T

The electrical power state change data or consumption data may be processed to provide relevant information on electrical activity of the power network 110, such as for example to build a household user profile, to detect and warn of increased electrical power consumption, and/or to provide recommendations for reducing energy consumption

In other embodiments of the invention, rather than sending an interrogation signal from the RFID reader to the electrical activity sensor devices in response to a command from the monitoring device 320 the RFID reader may send interrogation signals automatically to the RFID sensor devices without being commanded by the monitoring device; for example on a periodic basis.

In some embodiments of the system that monitoring device may be part of a home gateway system connected to an external internet network. Real time tracking of the total home power consumption could be provided by the home electricity provider via the internet network. For example the electricity provider could trigger reading phases of the RFID reader by transmitting signals from a remote server via the gateway device.

Although the present invention has been described hereinabove with reference to specific embodiments, the present invention is not limited to the specific embodiments, and modifications will be apparent to a skilled person in the art which lie within the scope of the present invention.

For instance, while the foregoing examples have been described with respect to a household power network system, it will be appreciated that embodiments of the invention may be applied to any power network to which electrical devices are connected. Moreover the system could be applied in security or safety applications to identify electrical devices which have been switched on or switched off.

Many further modifications and variations will suggest themselves to those versed in the art upon making reference to the foregoing illustrative embodiments, which are given by way of example only and which are not intended to limit the scope of the invention, that being determined solely by the appended claims. In particular the different features from different embodiments may be interchanged, where appropriate.

**Claims**

1. An electrical activity sensor attachable to a power cable of an electrical device and comprising
   a magnetometer for detecting a variation of magnetic field caused by current in the power cable when the electrical device is powered;
   a processor configured to determine electrical activity of the electrical device based on the detected variation of magnetic field; and
   an antenna for transmitting a signal representative of the electrical activity to a reader device.

2. An electrical activity sensor according to claim 1 wherein the antenna comprises an RFID antenna coupled to an RFID circuit

3. An electrical activity sensor according to claim 1 or 2 wherein the magnetometer is arranged on the power cable between two electrical wires of the power cable

4. An electrical activity sensor according to any preceding claim wherein the processor is configured to compute the standard deviation of magnetic field data acquired by the magnetometer and to compare the computed standard deviation with a set of thresholds.

5. An electrical activity sensor according to claim 4 wherein the computation of standard deviation is performed on two axes perpendicular to the longitudinal axis of the power cable

6. An electrical activity sensor according to claim 4 or 5, wherein the set of thresholds are based on the magnetic field variation measured on the power cable for an unpowered state of the electrical device

7. An electrical activity sensor according to any preceding claim wherein the magnetometer and the antenna are provided on a flexible substrate for wrapping at least partially around the power cord.

8. An electrical activity monitoring apparatus for monitoring the electrical power status of at least one electrical device connected to a power supply network by a respective power cable and, the electrical activity monitoring apparatus comprising:

   a reader module for reading data received wirelessly from at least one electrical activity sensor device attached to a respective power cable of an electrical device wherein the data is received from the electrical activity sensor sensor device via wireless transmission from an antenna of the electrical activity sensor device and the data is representative of electrical power status change of the electrical device; and
   a monitor device for determining from the data received by the reader module, which electrical devices of the network have changed electrical power status.

9. An electrical activity monitoring system comprising

at least one electrical activity sensor according to claim 1, and
an electrical activity monitoring apparatus according to claim 8.

10. A method of detecting electrical activity of an electrical device powered via a power cable comprising:

detecting a variation of magnetic field caused by current in the power cable when the electrical device is powered;
determining electrical activity of the electrical device based on the detected variation of magnetic field; and
transmitting a signal representative of the electrical activity to a reader device.

11. A method according to claim 10, wherein determining electrical activity of the electrical device comprises computing the standard deviation of magnetic field data acquired by the magnetometer and comparing the computed standard deviation with a set of thresholds.

12. A method according to claim 11 wherein the computation of standard deviation is performed on two axes perpendicular to the longitudinal axis of the power cable

13. A method according to claim 11 or 12, wherein the set of thresholds are based on the magnetic field variation measured on the power cable for an unpowered state of the electrical device

14. A computer program product for a programmable apparatus, the computer program product comprising a sequence of instructions for implementing a method according to any one of claims 10 to 13 when loaded into and executed by the programmable apparatus.

FIG. 1

**FIG. 2**

220
210
230
215
245
240
250

Ultra low power micro-controller

Battery

**FIG. 3**

Total magnetic field
(Time variable)

Current induced magnetic field
(Time variable)

$2\pi ft$

Earth magnetic field
(Stationary)

Bmin

BMax

**FIG. 4**

**FIG. 5**

$B_1 = \mu_0 I / 2\pi r$ ⊙ $\vec{B_1}$ ⊗ $\vec{B'}_2$ ; $B'_2 = \mu_0 I / 2\pi d_2$

⊗ $\vec{B'}_1$ ⊗ $\vec{B_2}$

$B'_1 = \mu_0 I / 2\pi d_1$ ⊗ $\vec{B'}_1$ ⊙ $\vec{B_2}$ ; $B_2 = \mu_0 I / 2\pi r$

**FIG. 6**

**FIG. 7**

FIG. 8

## Switch On and switch OFF from Freescale MAG3110

FIG. 9A

## Switch On and switch OFF from Freescale MAG3110

FIG. 9B

## Switch On and switch OFF from Freescale
## MAG3110

FIG. 9C

## Switch OFF and Switch On from ST sensors

**FIG. 10A**

## Switch OFF and Switch On from ST sensors

**FIG. 10B**

## Switch OFF and Switch On from ST sensors

FIG. 10C

## Switch OFF and Switch On from ST sensors with kettle

FIG. 11A

## Switch OFF and Switch On from ST sensors with kettle

Legend: B_y kettle in Gauss; B_y lamp in gauss

**FIG. 11B**

## Switch OFF and Switch On from ST sensors with kettle

Legend: B_z kettle in Gauss; B_z lamp in gauss

**FIG. 11C**

FIG. 12

FIG. 13A

Threshold Configuration — S11

Magnetic Field Variation Measurement — S12

Compute Standard Deviation of Magnetic Field Variation — S13

Compare Computed SD and Thresholds — S14

ON/OFF Activity? — Y → Write to RFID Chip — S15

Start

Set Configuration Registers by WRITE Process — S101

Determine the Standard deviations (SDxt, SDyt, & SDzt) of Magnetic Field measured by the magnetometer on X, Y & Z axes in OFF state & set them as threshold — S102

Declaration of NXP Address and ID-Number — S103

Read Magnetic Field of X, Y & Z axes & compute their Standard Deviations as SDx, SDy, SDz — S104

Is SDx > 3xSDxt ? — S105
Yes → WRITE ON to NXP — S106
No ↓

Is SDy > 3xSDyt ? — S107
Yes → WRITE ON to NXP — S108
No ↓

WRITE OFF to NXP — S111 ← No — Is SDz > 3xSDzt ? — S109
Yes → WRITE ON to NXP — S110

FIG. 13B

Start

Set Configuration Registers by WRITE Process;
Declaration of NXP Address and ID-Number

Compute the Resultant Magnetic Field by combining all
three, X, Y & Z, axes of magnetometer in OFF state

Determine the standard deviations (SDt) of Resultant
Magnetic Field data in OFF state & set it as threshold

Read Magnetic Field of all axes &
compute first resultants and then
standard deviation (SD)

WRITE OFF to NXP

Is SD >
3xSDt ?

No

Yes

WRITE ON to NXP

**FIG. 14**

Start

Set Configuration Registers by WRITE Process;
Declaration of NXP Address and ID-Number

**Calibration Phase**

Compute the Resultant Magnetic Field by
combining all three, X, Y & Z, axes of
magnetometer for different states, like
OFF, ON1, ON2...,ON(n-1), ONn states

Determine the standard deviations (SDtoff,
SDt1...SDtn) of different Resultant Magnetic
Fields data for OFF, ON1, ON2...,ONn states

Is Cal-Button
pressed?

Yes

No — Use previously calibrated
standard deviation values
as threshold for different
ON states

Read Magnetic Field of all axes &
compute first resultants and then
standard deviation (SD)

Is SD >
SDtn ? — Yes — WRITE ONn to NXP

No

Is SDt(n-
1) <SD< SDtn-? — Yes — WRITE ON(n-1) to NXP

'n' Different ON states

WRITE OFF to NXP — No — Is SDtoff <SD<
SDt1 ? — Yes — WRITE ONn to NXP

**FIG. 15**

24

**FIG. 16**

Europäisches
Patentamt

European
Patent Office

Office européen
des brevets

## EUROPEAN SEARCH REPORT

Application Number

EP 16 18 7161

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | GB 2 489 517 A (SEAMLESS SENSING LTD [GB]) 3 October 2012 (2012-10-03) * abstract; claims 1-27; figures 1-4 * * page 1, line 28 - page 5, line 8 * * page 5, line 30 - page 20, line 2 * ----- | 1-14 | INV. G01R21/01 G01D4/00 H02J3/14 |
| X | US 2012/280828 A1 (KIM MOON J [US]) 8 November 2012 (2012-11-08) * abstract; claims 1-26; figures 1A-5 * * paragraph [0012] - paragraph [0016] * * paragraph [0025] - paragraph [0045] * ----- | 1-14 | |
| X | EP 2 916 464 A1 (THOMSON LICENSING [FR]) 9 September 2015 (2015-09-09) * abstract; claims 1-15; figures 1-5 * * paragraph [0006] - paragraph [0030] * * paragraph [0032] - paragraph [0064] * ----- | 8,10-14 | |
| X | US 8 442 792 B1 (ELBERBAUM DAVID [JP]) 14 May 2013 (2013-05-14) * abstract; claims 1-20; figures 1-11D * * column 2, line 21 - column 6, line 45 * * column 7, line 54 - column 22, line 32 * ----- | 8,10-14 | |

TECHNICAL FIELDS
SEARCHED    (IPC)

G01R
G01D
H02J

The present search report has been drawn up for all claims

| Place of search | Date of completion of the search | Examiner |
|---|---|---|
| Munich | 30 January 2017 | Nadal, Rafael |

EPO FORM 1503 03.82 (P04C01)

## ANNEX TO THE EUROPEAN SEARCH REPORT
## ON EUROPEAN PATENT APPLICATION NO.

EP 16 18 7161

This annex lists the patent family members relating to the patent documents cited in  the above-mentioned European search report.
The members are as contained in the European Patent Office EDP file on
The European Patent Office is in no way liable for these particulars which are merely given for the purpose of information.

30-01-2017

| Patent document cited in search report | | Publication date | Patent family member(s) | | Publication date |
|---|---|---|---|---|---|
| GB 2489517 | A | 03-10-2012 | NONE | | |
| US 2012280828 | A1 | 08-11-2012 | NONE | | |
| EP 2916464 | A1 | 09-09-2015 | CN | 104898532 A | 09-09-2015 |
| | | | EP | 2916464 A1 | 09-09-2015 |
| | | | EP | 2916467 A2 | 09-09-2015 |
| | | | JP | 2015171320 A | 28-09-2015 |
| | | | KR | 20150104530 A | 15-09-2015 |
| | | | US | 2015253362 A1 | 10-09-2015 |
| US 8442792 | B1 | 14-05-2013 | AU | 2013335252 A1 | 09-04-2015 |
| | | | AU | 2015230795 A1 | 15-10-2015 |
| | | | CA | 2885589 A1 | 01-05-2014 |
| | | | CN | 104755945 A | 01-07-2015 |
| | | | EA | 201500443 A1 | 30-11-2015 |
| | | | EP | 2912478 A1 | 02-09-2015 |
| | | | JP | 6023344 B2 | 09-11-2016 |
| | | | JP | 2016505805 A | 25-02-2016 |
| | | | KR | 20140053761 A | 08-05-2014 |
| | | | KR | 20140114321 A | 26-09-2014 |
| | | | KR | 20140114322 A | 26-09-2014 |
| | | | KR | 20140114323 A | 26-09-2014 |
| | | | SG | 11201502494V A | 29-04-2015 |
| | | | US | 8442792 B1 | 14-05-2013 |
| | | | US | 8594965 B1 | 26-11-2013 |
| | | | US | 8639465 B1 | 28-01-2014 |
| | | | US | 2014117083 A1 | 01-05-2014 |
| | | | WO | 2014065940 A1 | 01-05-2014 |

EPO FORM P0459

For more details about this annex : see Official Journal of the European Patent Office, No. 12/82